# EUROPÄISCHE PATENTANMELDUNG

(11) **EP 4 818 640 A1**
(43) Veröffentlichungstag der Anmeldung: **07.10.2026**
(21) Anmeldenummer: 26162569.3
(22) Anmeldetag: 05.03.2026
(51) Int. Cl.: G01C 15/00

(54) **LASEREINHEIT FÜR EINEN ROTATIONSLASER UND ROTATIONSLASER MIT DER LASEREINHEIT**

(30) Priorität: 20.03.2025 DE 102025110724
(71) Anmelder: Robert Bosch GmbH, 70442 Stuttgart (DE)
(72) Erfinder: Zibold, Tobias, 70567 Stuttgart (DE); Hahl, Markus, 70825 Korntal-Muenchingen (DE); Carabelli, Ben William, 70771 Leinfelden-Echterdingen (DE); Roehm, Tobias, 72218 Wildberg-Sulz (DE); Peh, Wei Loon, 11600 Georgetown, Penang (MY); LAM, Keith, Bracknell, RG2 6FD (GB)

(57) **Zusammenfassung**

Bei einer Lasereinheit (130) für einen Rotationslaser, mit einem Lasermodulgehäuse (210), in dem eine Laserdiode (135) zur Erzeugung eines Laserstrahls (251) sowie eine Kollimationslinse (230) zur Kollimation des Laserstrahls (251) angeordnet sind, wobei der Laserdiode (135) eine Monitordiode (299) zugeordnet ist, und wobei eine automatische Leistungsregelungsschaltung (410) zur automatischen Reglung einer Laserleistung der Laserdiode (135) basierend auf einer Messung der Laserleistung durch die Monitordiode (299) vorgesehen ist, ist eine Fotodiode (260) für eine von der Monitordiode (299) unabhängige Messung der Laserleistung vorgesehen.

## Beschreibung

### Stand der Technik

Die vorliegende Erfindung betrifft eine Lasereinheit für einen Rotationslaser, mit einem Lasermodulgehäuse, in dem eine Laserdiode zur Erzeugung eines Laserstrahls sowie eine Kollimationslinse zur Kollimation des Laserstrahls angeordnet sind, wobei der Laserdiode eine Monitordiode zugeordnet ist, und wobei eine automatische Leistungsregelungsschaltung zur automatischen Reglung einer Laserleistung der Laserdiode, basierend auf einer Messung der Laserleistung durch die Monitordiode, vorgesehen ist.

Aus dem Stand der Technik ist ein Rotationslaser mit einer derartigen Lasereinheit bekannt. Die Lasereinheit weist ein Lasermodulgehäuse auf, in dem eine Laserdiode zur Erzeugung eines Laserstrahls sowie eine Kollimationslinse zur Kollimation des Laserstrahls angeordnet sind. Der Laserdiode ist dabei eine Monitordiode zugeordnet. Des Weiteren ist eine automatische Leistungsregelungsschaltung zur automatischen Reglung einer Laserleistung der Laserdiode, basierend auf einer Messung der Laserleistung durch die Monitordiode, vorgesehen.

### Offenbarung der Erfindung

Die Erfindung betrifft eine Lasereinheit für einen Rotationslaser, mit einem Lasermodulgehäuse, in dem eine Laserdiode zur Erzeugung eines Laserstrahls sowie eine Kollimationslinse zur Kollimation des Laserstrahls angeordnet sind, wobei der Laserdiode eine Monitordiode zugeordnet ist, und wobei eine automatische Leistungsregelungsschaltung zur automatischen Reglung einer Laserleistung der Laserdiode, basierend auf einer Messung der Laserleistung durch die Monitordiode, vorgesehen ist. Eine Fotodiode ist für eine von der Monitordiode unabhängige Messung der Laserleistung vorgesehen.

Die Erfindung ermöglicht somit die Bereitstellung einer Lasereinheit für einen Rotationslaser, bei der durch die von der Monitordiode unabhängige Messung der Laserleistung durch die Fotodiode ein sicherer und zuverlässiger Betrieb ermöglicht werden kann.

Die Monitordiode ist vorzugsweise eine in die Laserdiode integrierte Monitordiode.

Durch die Integration der Monitordiode in die Laserdiode kann ein kompakter Aufbau der Lasereinheit ermöglicht werden.

Die Fotodiode ist bevorzugt einer Schutzschaltung zugeordnet, welche dazu ausgebildet ist, die Laserdiode über eine Steuerleitung durch eine Unterbrechung der Stromzufuhr zur Laserdiode zu deaktivieren oder die automatische Leistungsregelungsschaltung über eine Steuerleitung zu deaktivieren, falls die von der Fotodiode gemessene Laserleistung einen vorgegebenen Laserleistungsgrenzwert überschreitet.

Somit kann einfach und unkompliziert ein sicherer Betrieb der Lasereinheit ermöglicht werden.

Der Laserdiode ist vorzugsweise ein Laserdioden-Halter zugeordnet, der Fotodiode ein Fotodioden-Halter und/oder der Kollimationslinse ein Kollimationslinsen-Halter.

Somit kann eine sichere und robuste Anordnung der Laserdiode, der Fotodiode und/oder der Kollimationslinse in der Lasereinheit ermöglicht werden.

Bevorzugt weist das Lasermodulgehäuse eine Aufnahme auf, die den Laserdioden-Halter zur Aufnahme der Laserdiode und den Fotodioden-Halter zur Aufnahme der Fotodiode ausbildet, wobei ein Strahlenteiler in der Aufnahme angeordnet ist, und wobei die Laserdiode auf einer eingehenden Seite des Strahlenteilers angeordnet ist und die Fotodiode auf einer ausgehenden Seite des Strahlenteilers angeordnet ist.

Somit können eine einfache und unkomplizierte Bereitstellung des Laserdioden-Halters und des Fotodioden-Halters sowie ein kompakter Aufbau der Lasereinheit durch Verwendung des Strahlenteilers ermöglicht werden.

Vorzugsweise ist die Kollimationslinse auf einer weiteren ausgehenden Seite des Strahlenteilers angeordnet.

Somit kann auf einfache Art und Weise eine geeignete Anordnung der Kollimationslinse ermöglicht werden.

Gemäß einer Ausführungsform weist das Lasermodulgehäuse eine erste Aufnahme auf, die als Fotodioden-Halter zur Aufnahme der Fotodiode ausgebildet ist, und eine zweite Aufnahme, die als Laserdioden-Halter zur Aufnahme der Laserdiode ausgebildet ist, wobei die erste Aufnahme senkrecht zur zweiten Aufnahme angeordnet ist und die zweite Aufnahme kollinear zu einer optischen Achse der Kollimationslinse angeordnet ist.

Somit kann leicht und unkompliziert eine alternative Ausbildung des Fotodioden-Halters und des Laserdioden-Halters ermöglicht werden.

Vorzugsweise ist die erste Aufnahme entlang einer Längserstreckung des Lasermodulgehäuses von der zweiten Aufnahme beabstandet angeordnet.

Somit kann auf einfache Art und Weise eine geeignete Anordnung der zweiten Aufnahme relativ zur ersten Aufnahme ermöglicht werden, durch die eine Durchführung einer unabhängigen Messung der Laserleistung durch die Fotodiode ermöglicht werden kann.

Bevorzugt ist die erste Aufnahme entlang einer Richtung größter Divergenz einer Abstrahlcharakteristik der Laserdiode angeordnet.

Somit kann ein sicherer und zuverlässiger Betrieb der Lasereinheit ermöglicht werden.

Gemäß einer Ausführungsform ist eine Leiterplatte vorgesehen, auf der die Laserdiode und die Fotodiode angeordnet sind, wobei die Leiterplatte und der Fotodioden-Halter am Laserdioden-Halter angeordnet sind.

Somit kann leicht und unkompliziert eine weitere Ausgestaltung des Fotodioden-Halters und des Laserdioden-Halters ermöglicht werden.

Vorzugsweise weist die Leiterplatte zumindest einen ersten Leiterplattenabschnitt und einen senkrecht oder parallel zum ersten Leiterplattenabschnitt angeordneten zweiten Leiterplattenabschnitt auf, wobei die Laserdiode am ersten Leiterplattenabschnitt angeordnet ist und die Fotodiode am zweiten Leiterplattenabschnitt angeordnet ist.

Somit kann eine sichere und zuverlässige Anordnung der Fotodiode und der Laserdiode auf der Leiterplatte ermöglicht werden.

Bevorzugt ist die Leiterplatte als flexible Leiterplatte ausgebildet.

Somit kann auf einfache Art und Weise die senkrechte oder parallele Anordnung des zweiten Leiterplattenabschnitts relativ zum ersten Leiterplattenabschnitt der Leiterplatte ermöglicht werden.

Vorzugsweise weist das Lasermodulgehäuse eine Aufnahme auf, die den Kollimationslinsen-Halter ausbildet.

Somit kann leicht und unkompliziert eine alternative Ausgestaltung des Kollimationslinsen-Halters ermöglicht werden.

Bevorzugt ist ein Abstand zwischen der Laserdiode und der Kollimationslinse veränderbar, wobei der Laserdioden-Halter der Laserdiode in einer Aufnahme des Lasermodulgehäuses entlang der Längserstreckung des Lasermodulgehäuses verschiebbar angeordnet ist und/oder der Kollimationslinsen-Halter der Kollimationslinse in einer Innenaufnahme des Lasermodulgehäuses entlang der Längserstreckung des Lasermodulgehäuses verschiebbar abgeordnet ist, wobei die Innenaufnahme kollinear zu einer optischen Achse der Kollimationslinse angeordnet ist.

Somit kann auf einfache Art und Weise der Abstand zwischen der Laserdiode und der Kollimationslinse eingestellt werden.

Darüber hinaus betrifft die vorliegende Erfindung einen Rotationslaser mit der beschriebenen Lasereinheit.

Die Erfindung ermöglicht somit die Bereitstellung eines Rotationslasers mit einer Lasereinheit, bei der durch die von der Monitordiode unabhängige Messung der Laserleistung durch die Fotodiode ein sicherer und zuverlässiger Betrieb der Lasereinheit und somit des Rotationslasers ermöglicht werden kann.

### Kurze Beschreibung der Zeichnungen

Die Erfindung ist anhand von in den Zeichnungen dargestellten Ausführungsbeispielen in der nachfolgenden Beschreibung näher erläutert. Es zeigen:
- Fig. 1: eine perspektivische Ansicht eines erfindungsgemäßen Rotationslasers mit einer Lasereinheit,
- Fig. 2: eine schematische Ansicht der Lasereinheit von Fig. 1,
- Fig. 3: eine schematische Ansicht einer der Lasereinheit von Fig. 1 und Fig. 2 zugeordneten Leiterplatte,
- Fig. 4: eine schematische Ansicht einer der Lasereinheit von Fig. 1 zugeordneten ersten Schaltung,
- Fig. 5: eine schematische Ansicht einer alternativen Ausgestaltung der Lasereinheit von Fig. 1,
- Fig. 6: eine perspektivische Explosionsansicht einer weiteren Ausgestaltung der Lasereinheit von Fig. 1,
- Fig. 7: eine Schnittansicht der Lasereinheit von Fig. 6,
- Fig. 8: eine schematische Ansicht einer der Lasereinheit von Fig. 1 zugeordneten zweiten Schaltung,
- Fig. 9: eine perspektivische Ansicht einer der Lasereinheit von Fig. 6 und Fig. 7 zugeordneten Leiterplatte mit einer Laserdiode und einer Fotodiode,
- Fig. 10: eine Ansicht der Leiterplatte mit der Laserdiode und der Fotodiode von Fig. 9, gesehen in Richtung eines Pfeils 901 von Fig. 9,
- Fig. 11: eine schematische Ansicht einer alternativen Ausgestaltung der Lasereinheit von Fig. 1,
- Fig. 12: eine perspektivische Ansicht einer der Lasereinheit von Fig. 6 und Fig. 7 zugeordneten alternativen Leiterplatte mit einer Laserdiode und einer Fotodiode,
- Fig. 13: eine Draufsicht auf eine erste Seite der Leiterplatte von Fig. 12,
- Fig. 14: eine Draufsicht auf eine zweite Seite der Leiterplatte von Fig. 12 und Fig. 13,
- Fig. 15: eine perspektivische Ansicht der Leiterplatte von Fig. 12 bis Fig. 14 im verbauten Zustand mit Fixierelementen,
- Fig. 16: eine perspektivische Ansicht der Lasereinheit von Fig. 6 und Fig. 7 mit der Leiterplatte von Fig. 12 bis Fig. 15,
- Fig. 17: eine perspektivische Ansicht der Lasereinheit von Fig. 16 mit einem an der Leiterplatte angeordneten Abschirmungselement,
- Fig. 18: eine perspektivische Ansicht der Lasereinheit von Fig. 17 mit der Leiterplatte und eine perspektivische Ansicht des Abschirmungselements, und
- Fig. 19: eine Schnittansicht der Lasereinheit von Fig. 18.

### Beschreibung der Ausführungsbeispiele

In den Figuren werden Elemente mit gleicher oder vergleichbarer Funktion mit identischen Bezugszeichen versehen und nur einmal genauer beschrieben.

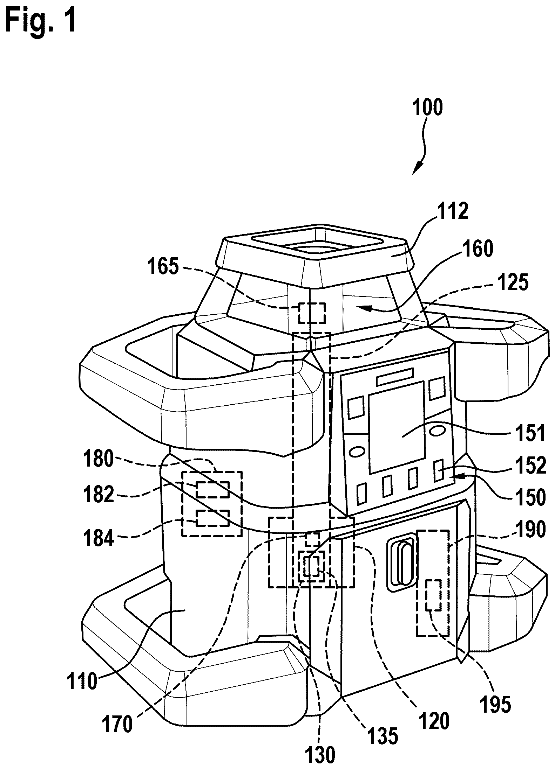

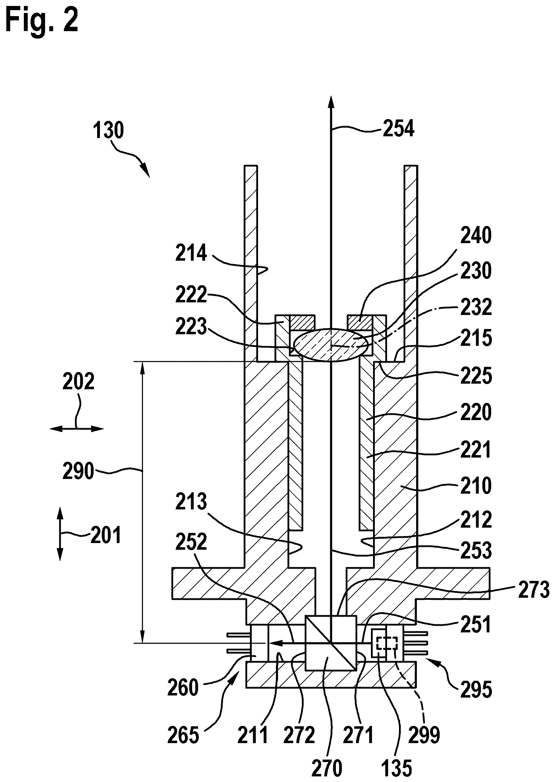

Fig. 1 zeigt einen beispielhaften Rotationslaser 100 mit einem Lasergehäuse 110, in dem eine Lasereinheit 130 mit einer Laserdiode 135 zur Erzeugung eines Laserstrahls (251 in Fig. 2) angeordnet ist. Unter einem "Rotationslaser" kann im Kontext der vorliegenden Erfindung auch ein Baulaser oder ein Nivellierlaser verstanden werden. Des Weiteren ist in dem Lasergehäuse 110 beispielhaft eine Antriebseinheit 120 zum rotierenden Antrieb einer Antriebswelle 125 angeordnet.

Die Lasereinheit 130 ist illustrativ derart an der Antriebswelle 125 angeordnet, dass durch eine Rotation der Antriebswelle 125 der von der Lasereinheit 130 erzeugte Laserstrahl (251 in Fig. 2) in einer zugeordneten Ebene rotiert. Hierzu ist der Antriebswelle 125 vorzugsweise ein Rotationskopf 160 mit einem Strahlenumleiter 165 zugeordnet. Der Strahlenumleiter 165 ist bevorzugt dazu ausgebildet, den Laserstrahl (254 in Fig. 2) umzulenken, wodurch der Laserstrahl (254 in Fig. 2) die zugeordnete Ebene projiziert. Alternativ ist der Strahlenumleiter 165 als Strahlteiler ausgebildet, wodurch zusätzlich zur projizierten Ebene ein zur Laserebene senkrecht stehender Laserstrahl entlang der Laserachse (254 in Fig. 2) emittiert wird. Je nach Bauart des Rotationslasers 100 kann die projizierte Ebene horizontal, vertikal oder z.B. mit einem definierten Neigungswinkel zur Erdoberfläche verlaufen. Vorzugsweise ist die Antriebseinheit 120 als Elektromotor ausgebildet.

Darüber hinaus ist in dem Lasergehäuse 110 bevorzugt eine Elektronikeinheit 190 mit einer Regelungs- und Überwachungsvorrichtung 195 angeordnet. Die Regelungs- und Überwachungsvorrichtung 195 ist vorzugsweise zur Regelung einer Laserleistung der Lasereinheit 130 in Abhängigkeit von einer Betriebsart ausgebildet. Hierbei wird eine Rotationsgeschwindigkeit der Antriebswelle 125 der Antriebseinheit 120 gesteuert oder geregelt. Hierzu ist der Antriebswelle 125 bevorzugt eine Ermittlungseinheit 170 zugeordnet.

Gemäß einer Ausführungsform ist dem Lasergehäuse 110 ein dem Rotationskopf 160 zugeordneter Schutzkäfig 112 zum Schutz vor einem Anschlagen des Rotationskopfs 160 zugeordnet.

Der Elektronikeinheit 190 ist bevorzugt eine Bedieneinheit 150 mit einem Display 151 und/oder einer Eingabeeinheit 152 zugeordnet. Die Bedieneinheit 150 ist dabei bevorzugt steuer- oder regeltechnisch mit der Elektronikeinheit 190, insbesondere mit der Regelungs- und Überwachungsvorrichtung 195, verbunden. Die Eingabeeinheit 152 umfasst vorzugsweise zumindest ein Tastenfeld. In einer minimierten Ausgestaltung weist die Eingabeeinheit 152 lediglich einen An-/Aus-Schalter, insbesondere einen An-/Aus-Taster, auf. Alternativ weist die Eingabeeinheit 152 einen Drehregler, einen Touchscreen, einen Schieberegler, eine Fernbedienung oder dergleichen auf. Über die Eingabeeinheit 152 ist durch einen Nutzer z.B. eine Rotationsgeschwindigkeit für die Antriebswelle 125 eingebbar. Alternativ ist die Rotationsgeschwindigkeit der Lasereinheit 130 in einer Betriebsart automatisch regelbar.

Vorzugsweise weist der Rotationslaser 100 eine Nivelliereinheit 180 auf. Die Nivelliereinheit 180 weist bevorzugt zumindest einen Neigungssensor 184 auf, der dazu ausgebildet ist, eine Neigung des Rotationskopfs 160, insbesondere des Strahlenumleiters 165, und/oder der Lasereinheit 130 zu einer vorgegebenen, bevorzugt horizontalen Richtung bzw. zu einem Lot zu bestimmen. Darüber hinaus weist die Nivelliereinheit 180 vorzugsweise mindestens einen Neigungseinstellmotor 182 auf, der dazu ausgebildet ist, den Rotationskopf 160, insbesondere den Strahlenumleiter 165, und/oder die Lasereinheit 130, in Abhängigkeit von einer mittels des zumindest einen Neigungssensors 184 bestimmten Lage, vorzugsweise einer Neigung der Lasereinheit 130 und/oder des Rotationskopfs 160, bevorzugt zum Lot auszurichten.

Fig. 2 zeigt eine beispielhafte Ausgestaltung der Lasereinheit 130 des Rotationslasers 100 von Fig. 1. Der Lasereinheit 130 ist illustrativ ein Lasermodulgehäuse 210 zugeordnet, in dem die Laserdiode 135 zur Erzeugung eines Laserstrahls 251 sowie eine Kollimationslinse 230 zur Kollimation des Laserstrahls 251 angeordnet sind. Der Laserdiode 135 ist eine Monitordiode 299 zugeordnet. Die Monitordiode 299 ist zur Messung einer der Laserdiode 135 zugeordneten Laserleistung ausgebildet. Gemäß einer Ausführungsform ist die Monitordiode 299 eine in die Laserdiode 135 integrierte Monitordiode. Eine derartige Laserdiode 135 mit integrierter Monitordiode 299 ist hinreichend aus dem Stand der Technik bekannt, weshalb zwecks Knappheit der Beschreibung hier auf eine nähere Beschreibung verzichtet wird.

Erfindungsgemäß weist die Lasereinheit 130 eine Fotodiode 260 auf, die für eine von der Monitordiode 299 unabhängige Messung der Laserleistung vorgesehen ist.

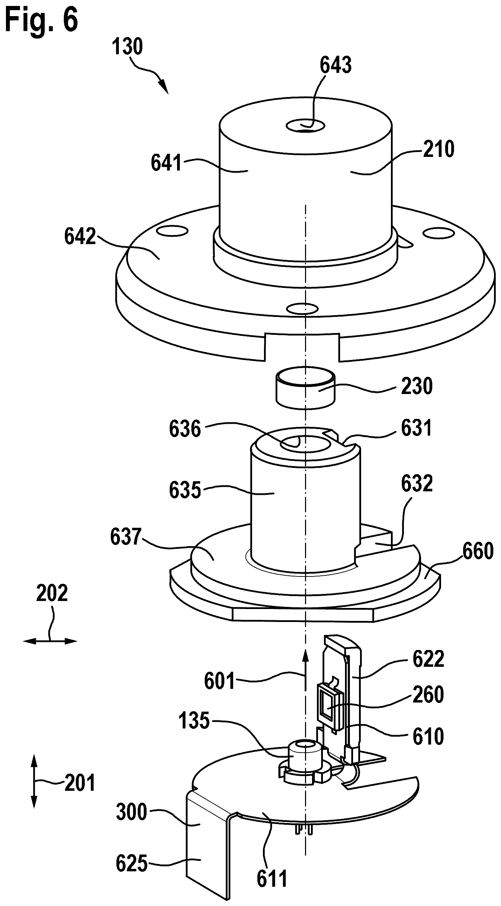

Vorzugsweise ist der Laserdiode 135 ein Laserdioden-Halter 295 (660 in Fig. 6), der Fotodiode 260 ein Fotodioden-Halter 265 (622 in Fig. 6) und/oder der Kollimationslinse 230 ein Kollimationslinsen-Halter 220 zugeordnet. Der Kollimationslinsen-Halter 220 ist dabei in einer Innenaufnahme 212 des Lasermodulgehäuses 210 angeordnet. Die Innenaufnahme 212 ist entlang einer Längserstreckung 201 des vorzugsweise zylindrischen Lasermodulgehäuses 210 ausgerichtet. Des Weiteren ist die Innenaufnahme 212 bevorzugt kollinear zu einer optischen Achse 232 der Kollimationslinse 230 angeordnet.

Bevorzugt ist ein Abstand 290 zwischen der Laserdiode 135 und der Kollimationslinse 230 veränderbar. Hierzu ist der Kollimationslinsen-Halter 220 vorzugsweise entlang der Längserstreckung 201 des Lasermodulgehäuses 210 in der Innenaufnahme 212 verschiebbar angeordnet. Vorzugsweise ist der Kollimationslinse 230 eine Apertur 240 zugeordnet.

Illustrativ weist die Innenaufnahme 212 einen unteren Aufnahmebereich 213 auf, der sich über eine Bodenfläche 215 in einen oberen Aufnahmebereich 214 aufweitet. Ein illustrativ unterer Abschnitt 221 des Kollimationslinsen-Halters 220 ist beispielhaft im unteren Aufnahmebereich 213 der Innenaufnahme 212 angeordnet und ein illustrativ oberer Abschnitt 222 des Kollimationslinsen-Halters 220 ist vorzugsweise im oberen Aufnahmebereich 214 der Innenaufnahme 212 angeordnet. Hierbei ist eine Unterseite 225 des oberen Abschnitts 222 des Kollimationslinsen-Halters 220 illustrativ an der Bodenfläche 215 des oberen Aufnahmebereichs 214 angeordnet. Der obere Abschnitt 222 des Kollimationslinsen-Halters 220 weist beispielhaft eine Linsenaufnahme 223 auf, in der die Kollimationslinse 230 angeordnet ist.

Die Kollimationslinse 230 weist illustrativ die optische Achse 232 auf. Entlang der optischen Achse 232 wird der Laserstrahl 251 kollimiert. Die optische Achse 232 ist innerhalb vorgegebener Toleranzen bevorzugt parallel zur Längserstreckung 201 des Lasermodulgehäuses 210 angeordnet. Unter einer optischen Achse 232 ist im Kontext der vorliegenden Erfindung eine Gerade durch ein Zentrum, insbesondere ein Krümmungszentrum einer optischen Vorrichtung, hier der Linse bzw. der Kollimationslinse 230, zu verstehen.

Gemäß Fig. 2 weist die Lasereinheit 130 einen Strahlenteiler 270 auf, der den von der Laserdiode 135 ausgehenden Laserstrahl 251 in vorzugsweise zwei ausgehende Laserstrahlen 252, 253 aufteilt. Hierzu ist die Laserdiode 135 auf einer eingehenden Seite 271 des Strahlenteilers 270 angeordnet. Die Fotodiode 260 ist vorzugsweise auf einer ausgehenden Seite 272 des Strahlenteilers 270 angeordnet. Bevorzugt ist die Kollimationslinse 230 auf einer weiteren ausgehenden Seite 273 des Strahlenteilers 270 angeordnet.

Das Lasermodulgehäuse 210 weist vorzugsweise eine Aufnahme 211 auf, die den Laserdioden-Halter 295 zur Aufnahme der Laserdiode 135 und den Fotodioden-Halter 265 zur Aufnahme der Fotodiode 260 ausbildet. Bevorzugt ist die Aufnahme 211 entlang einer senkrecht zur Längserstreckung 201 des Lasermodulgehäuses 210 angeordneten Querrichtung 202 des Lasermodulgehäuses 210 angeordnet. Vorzugsweise ist der Strahlenteiler 270 ebenfalls in der Aufnahme 211 angeordnet.

Illustrativ ist die Laserdiode 135 rechts vom Strahlenteiler 270 angeordnet und die Fotodiode 260 ist illustrativ links vom Strahlenteiler 270 angeordnet. Somit sind die Laserdiode 135 und die Fotodiode 260 illustrativ um 180° versetzt zueinander bzw. gegenüberliegend am Strahlenteiler 270 angeordnet. Hierbei kann die Laserdiode 135 auch illustrativ links vom Strahlenteiler 270 angeordnet sein und die Fotodiode 260 kann illustrativ rechts vom Strahlenteiler 270 angeordnet sein. Alternativ können die Laserdiode 135 und die Fotodiode 260 auch in einem anderen Winkel zueinander angeordnet sein, z.B. um 90° versetzt zueinander.

Der Laserstrahl 251 wird illustrativ in einen ausgehenden Laserstrahl 252, der zur Fotodiode 260 geleitet wird, und in einen ausgehenden Laserstrahl 253, der zur Kollimationslinse 230 geleitet wird, aufgeteilt. Der Laserstrahl 253 wird durch die Kollimationslinse 230 in einen kollimierten Laserstrahl 254 kollimiert bzw. gesammelt oder gebündelt. Hierbei werden die Strahlen des Laserstrahls 253 im Wesentlichen durch die Kollimationslinse 230 parallel ausgerichtet, sodass sie sich bei ihrer Ausbreitung nur minimal ausbreiten.

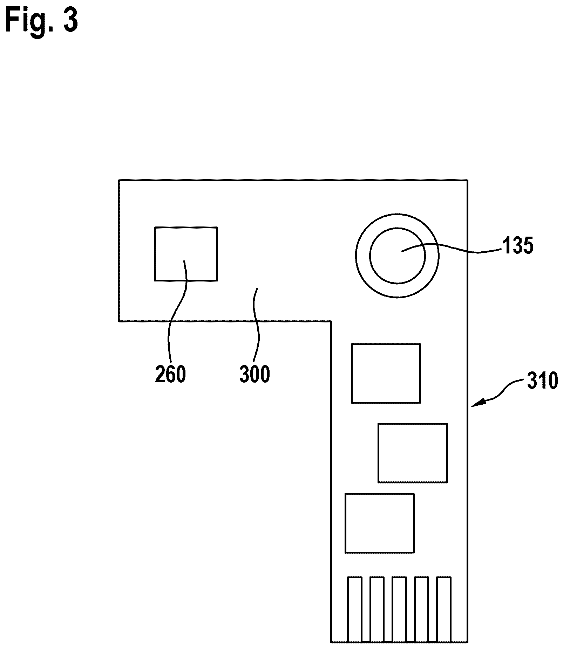

Fig. 3 zeigt eine der Lasereinheit 130 von Fig. 1 und Fig. 2 zugeordnete Leiterplatte 300. Auf der Leiterplatte 300 sind vorzugsweise die Laserdiode 135 von Fig. 1 und Fig. 2 und die Fotodiode 260 von Fig. 2 angeordnet. Bevorzugt sind auf der Leiterplatte 300 Schaltungsteile 310 angeordnet. Illustrativ sind drei Schaltungsteile 310 auf der Leiterplatte 300 angeordnet. Es wird jedoch darauf hingewiesen, dass die Leiterplatte 300 eine beliebige Anzahl von Schaltungsteilen 310 aufweisen kann.

Gemäß einer Ausführungsform ist die Leiterplatte 300 als flexible und faltbare Leiterplatte ausgebildet. Hierbei können Abschnitte der Leiterplatte 300 in vorgegebenen Winkeln oder parallel zueinander angeordnet werden.

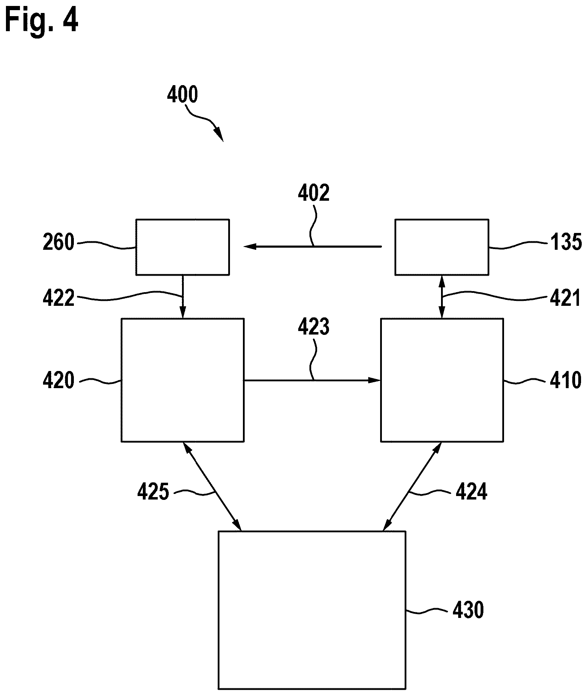

Fig. 4 zeigt eine der Lasereinheit 130 von Fig. 1 zugeordnete Schaltung 400. Die Schaltung 400 weist vorzugsweise zumindest eine der Laserdiode 135 zugeordnete automatische Leistungsregelungsschaltung 410 und eine einer entsprechenden Fotodiode, beispielsweise der Fotodiode 260 von Fig. 2, zugeordnete Schutzschaltung 420 auf.

Die Laserdiode 135 ist illustrativ über eine Verbindung 421 mit der automatischen Leistungsregelungsschaltung 410 verbunden. Die automatische Leistungsregelungsschaltung 410 ist bevorzugt zur automatischen Regelung einer Laserleistung der Laserdiode 135, basierend auf einer Messung der Laserleistung durch eine der Laserdiode 135 zugeordnete Monitordiode, z. B. die Monitordiode 299 von Fig. 2, ausgebildet. Bevorzugt ist die Verbindung 421 bidirektional. Eine derartige automatische Leistungsregelungsschaltung 410 ist aus dem Stand der Technik hinreichend bekannt und wird deshalb nicht näher beschrieben. Beispielhaft ist die automatische Leistungsregelungsschaltung 410 als Integralregler ausgebildet.

Der von der Laserdiode 135 ausgesendete Laserstrahl wird ebenfalls an die Fotodiode 260 geleitet, was durch einen Pfeil 402 visualisiert ist. In einer weiteren Ausgestaltung kann der Pfeil 402 auch Streulicht visualisieren bzw. umfassen. Die Fotodiode 260 ist bevorzugt über eine Verbindung 422 mit der Schutzschaltung 420 verbunden. Vorzugsweise ist die Verbindung 422 unidirektional. Bevorzugt werden über die Verbindung 422 von der Fotodiode 260 ermittelte Fotoströme an die Schutzschaltung 420 weitergegeben.

Die Fotodiode 260 ist, wie oben beschrieben, für eine von der Monitordiode 299 von Fig. 2 unabhängige Messung der Laserleistung vorgesehen. Die Schutzschaltung 420 ist bevorzugt über eine Steuerleitung 423 mit der automatischen Leistungsregelungsschaltung 410 verbunden und kann die automatische Leistungsregelungsschaltung 410 über die Steuerleitung 423 deaktivieren, falls die von der Fotodiode 260 gemessene Laserleistung einen vorgegebenen Laserleistungsgrenzwert überschreitet.

Darüber hinaus sind bevorzugt weitere Schaltungsteile 430 über eine Verbindung 425 mit der Schutzschaltung 420 verbunden. Vorzugsweise sind die weiteren Schaltungsteile 430 über eine Verbindung 424 mit der automatischen Leistungsregelungsschaltung 410 verbunden. Die weiteren Schaltungsteile 430 umfassen z.B. eine Strom-/Spannungsversorgung und/oder eine Steuereinheit, insbesondere die Elektronikeinheit 190 von Fig. 1 des Rotationslasers 100 von Fig. 1.

Bevorzugt basiert die Regelung der Laserleistung auf einem Vergleich der durch die Monitordiode 299 gemessenen Laserleistung zu einem vorgegebenen Laserleistungssollwert. Der Laserleistungssollwert ist dabei kleiner als der Laserleistungsgrenzwert für die Schutzschaltung 420. Sowohl der Laserleistungssollwert als auch der Laserleistungsgrenzwert werden z.B. von einer den Schaltungsteilen 430 zugeordneten Steuerschaltung konfiguriert und sind vorzugsweise veränderlich.

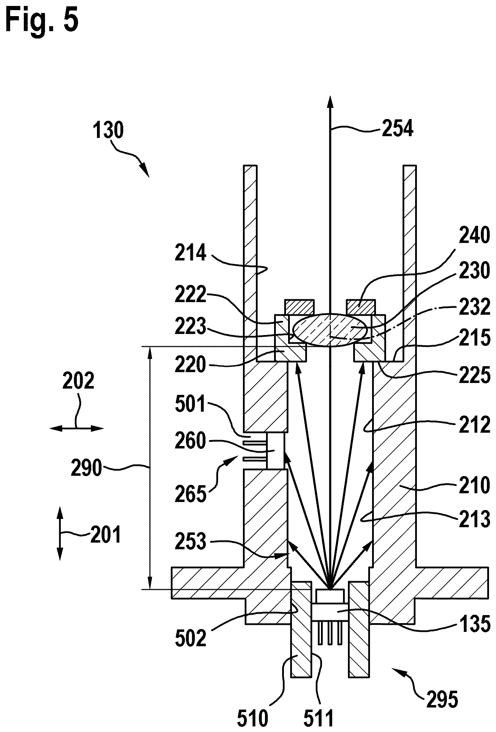

Fig. 5 zeigt eine alternative Ausgestaltung der Lasereinheit 130 von Fig. 1 mit der Laserdiode 135, der Fotodiode 260 und der Kollimationslinse 230. Analog zu Fig. 2 ist der Kollimationslinsen-Halter 220 im illustrativ oberen Aufnahmebereich 214 der Innenaufnahme 212 angeordnet.

Gemäß Fig. 5 weist der Kollimationslinsen-Halter 220 lediglich den oberen Abschnitt 222 von Fig. 2 auf. Bevorzugt liegt die Unterseite 225 des oberen Abschnitts 222 des Kollimationslinsen-Halters 220 an der Bodenfläche 215 des oberen Aufnahmebereichs 214 auf. Hierbei ist der Kollimationslinsen-Halter 220 vorzugsweise fest, d.h. unverschiebbar, in der Innenaufnahme 212 angeordnet.

Der Laserdioden-Halter 295 der Laserdiode 135 weist illustrativ einen Grundkörper 510 mit einer Innenaufnahme 511 auf, in der die Laserdiode 135 angeordnet ist. Vorzugsweise ist der Laserdioden-Halter 295 in einer Aufnahme 502 des Lasermodulgehäuses 210 angeordnet. Die Aufnahme 502 ist bevorzugt kollinear zur optischen Achse 232 der Kollimationslinse 230 angeordnet. Hierbei ist ein Mittelpunkt der Aufnahme 502 auf der optischen Achse 232 angeordnet. Gemäß einer Ausführungsform ist der Laserdioden-Halter 295 entlang der Längserstreckung 201 des Lasermodulgehäuses 210 in der Aufnahme 502 zum Einstellen des Abstands 290 zwischen der Laserdiode 135 und der Kollimationslinse 230 verschiebbar angeordnet.

Des Weiteren weist das Lasermodulgehäuse 210 beispielhaft eine Aufnahme 501 auf, die innerhalb vorgegebener Toleranzen senkrecht zur Aufnahme 502 des Laserdioden-Halters 295 angeordnet ist. Hierbei ist die Aufnahme 501 illustrativ innerhalb vorgegebener Toleranzen senkrecht zur Innenaufnahme 212 des Lasermodulgehäuses 210 angeordnet. Die Aufnahme 501 ist illustrativ im unteren Abschnitt 213 der Innenaufnahme 212 des Lasermodulgehäuses 210 ausgebildet. Beispielhaft bildet die Aufnahme 501 den Fotodioden-Halter 265 aus.

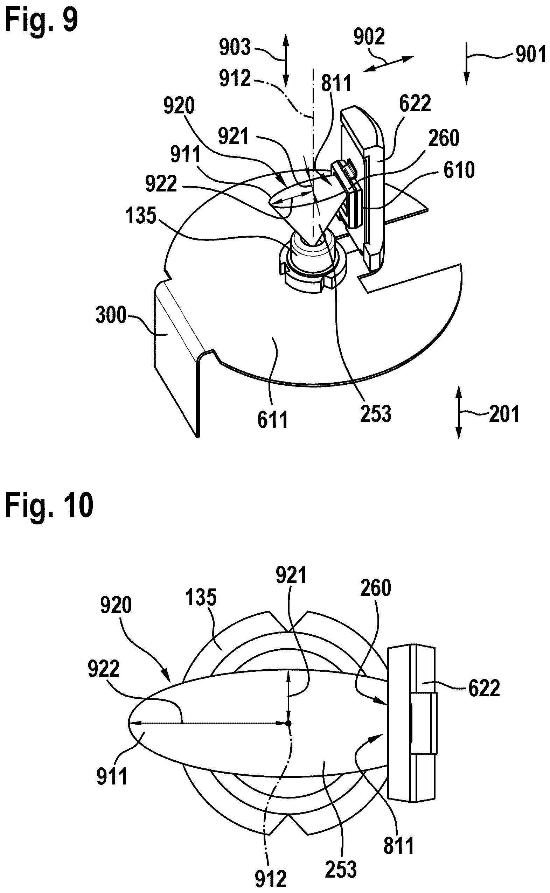

Die Aufnahme 501 bzw. der Fotodioden-Halter 265 ist illustrativ entlang der Längserstreckung 201 des Lasermodulgehäuses 210 von der Aufnahme 502 des Laserdioden-Halters 295 beabstandet angeordnet. Hierbei ist die Aufnahme 501 bevorzugt entlang einer Richtung (922 in Fig. 9) größter Divergenz einer Abstrahlcharakteristik (911 in Fig. 9) der Laserdiode 135 angeordnet. Ein der Fotodiode 260 zugeordneter Fotostrom resultiert dabei vorzugsweise aus einem Streulicht der Laserdiode 135 aufgrund der Divergenz des unkollimierten Laserstrahls 253 der Laserdiode 135.

Die Laserdiode 135 und die Fotodiode 260 können auf separaten Leiterplatten angeordnet sein. Hierbei sind die Leiterplatten bevorzugt als starre oder flexible Leiterplatten ausgebildet.

Fig. 6 zeigt eine weitere Ausgestaltung der Lasereinheit 130 von Fig. 1, bei der die Laserdiode 135 und die Fotodiode 260 beispielhaft auf einer gemeinsamen Leiterplatte 300 angeordnet sind. Bevorzugt ist die Leiterplatte 300, wie oben beschrieben, als flexible und faltbare Leiterplatte ausgebildet.

Illustrativ weist die Leiterplatte 300 zumindest einen ersten Leiterplattenabschnitt 611 und einen zweiten Leiterplattenabschnitt 610 auf. Vorzugsweise ist der zweite Leiterplattenabschnitt 610 nach Art eines Stanzbiegeteils ausgebildet. Beispielhaft ist der zweite Leiterplattenabschnitt 610 annähernd senkrecht zum ersten Leiterplattenabschnitt 611 angeordnet. Vorzugsweise bildet der erste Leiterplattenabschnitt 611 hierbei einen Bodenabschnitt 611 aus und der zweite Leiterplattenabschnitt 610 bildet einen Wandabschnitt 610 aus. Die Laserdiode 135 ist bevorzugt am ersten Leiterplattenabschnitt 611 bzw. dem Bodenabschnitt 611 angeordnet und die Fotodiode 135 ist am zweiten Leiterplattenabschnitt 610 bzw. dem Wandabschnitt 610 angeordnet.

Vorzugsweise ist dem ersten Leiterplattenabschnitt 611 ein Kontaktierungselement 625 zugeordnet. Das Kontaktierungselement 625 dient zum elektrischen Kontaktieren der Leiterplatte 300 mit zumindest einer Stromquelle.

Der Fotodiode 260, insbesondere dem zweiten Leiterplattenabschnitt 610, ist vorzugsweise ein Fotodioden-Halter 622 zugeordnet. Der Laserdiode 135 ist vorzugsweise ein Laserdioden-Halter 660 zugeordnet. Der Laserdioden-Halter 660 ist zur Anordnung der Laserdiode 135 im Lasermodulgehäuse 210 vorgesehen. Hierbei ist der Laserdioden-Halter 660 bevorzugt in einer Innenaufnahme 643 des Lasermodulgehäuses 210 angeordnet.

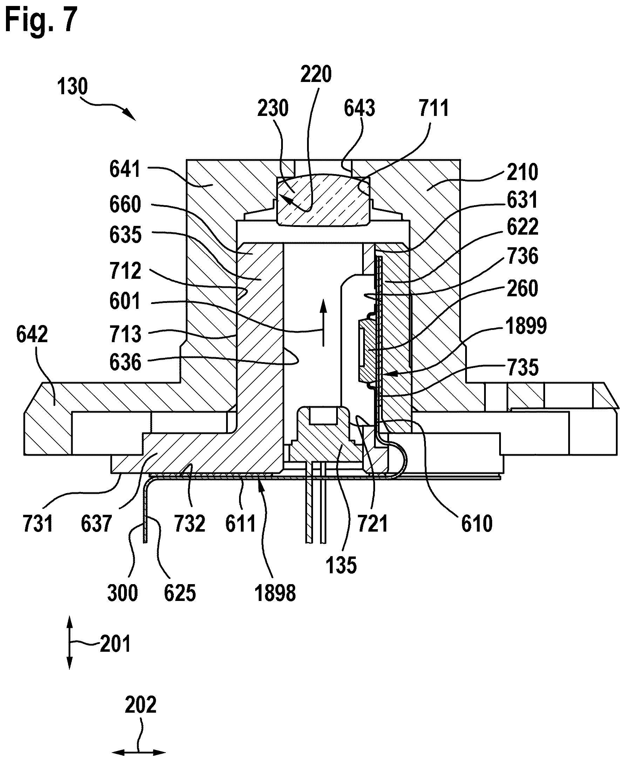

Der Laserdioden-Halter 660 weist illustrativ einen zylindrischen Grundkörper 635 mit einer Innenaufnahme 636 auf. Des Weiteren weist der zylindrische Grundkörper 635 beispielhaft an seinem Außenumfang eine Aufnahme 631 mit einer Ausnehmung (721 in Fig. 7) zur Anordnung der Fotodiode 260 in der Innenaufnahme 636 des Laserdioden-Halters 660 auf. An seiner vom Lasermodulgehäuse 210 abgewandten Seite weist der Laserdioden-Halter 660 illustrativ einen Umfangskragen 637 auf. Der Umfangskragen 637 weist beispielhaft eine der Aufnahme 631 zugeordnete Ausnehmung 632 auf, die zur Anordnung der Fotodioden-Halters 622 in der Aufnahme 631 ausgebildet ist.

Das Lasermodulgehäuse 210 weist vorzugsweise einen zylindrischen Grundkörper 641 mit der Innenaufnahme 643 zum Ausgeben des durch die Laserdiode 135 erzeugten und kollimierten Laserstrahls 254 von Fig. 2 und Fig. 5 auf. Hierbei übernimmt die Innenaufnahme 643 vorzugsweise die Funktion der Apertur 240 von Fig. 2. Vorzugsweise weist das Lasermodulgehäuse 210 einen der Laserdiode 135 zugewandten Umfangskragen 642 auf.

Die flexible und faltbare Leiterplatte 300 ist beispielhaft am Laserdioden-Halter 660 angeordnet. Hierzu wird der erste Leiterplattenabschnitt 611 vorzugsweise derart am Umfangskragen 637 angeordnet, dass die Laserdiode 135 in der **In**nenaufnahme 636 des Laserdioden-Halters 660 angeordnet ist. Bei der Anordnung der Laserdiode 135 in der Innenaufnahme 636 ist der zweite Leiterplattenabschnitt 610 mit dem Fotodioden-Halter 622 nicht senkrecht zum ersten Leiterplattenabschnitt 611 angeordnet. Hierdurch kann der zweite Leiterplattenabschnitt 610 mittels eines Umbiegens durch die Ausnehmung 632 in der Aufnahme 631 des Laserdioden-Halters 660 angeordnet werden. Vorzugsweise ist der Fotodioden-Halter 622 am Laserdioden-Halter 660, vorzugsweise der Aufnahme 631 des Laserdioden-Halters 660, befestigt. Durch das Umbiegen erfolgt die Anordnung des zweiten Leiterplattenabschnitts 610 annähernd senkrecht zum ersten Leiterplattenabschnitt 611, sodass die Fotodiode 260 analog zu Fig. 5 im Wesentlichen senkrecht zu einer Abstrahlrichtung 601 eines Laserstrahls 253 von Fig. 2 und Fig. 5 der Laserdiode 135 angeordnet ist.

Die Kollimationslinse 230 ist bevorzugt in der Innenaufnahme 643 des Lasermodulgehäuses 210 angeordnet und befestigt. Der Laserdioden-Halter 660 mit der Leiterplatte 300, der Laserdiode 135 sowie der Fotodiode 260 ist ebenfalls in der Innenaufnahme 643 angeordnet. Hierzu wird der Laserdioden-Halter 660 z.B. in die Innenaufnahme 643 des Lasermodulgehäuses 210 eingepresst.

Fig. 7 zeigt die Lasereinheit 130 von Fig. 6 im montierten Zustand. Hierbei ist die Kollimationslinse 230 bevorzugt in einem illustrativ oberen Aufnahmeabschnitt 711 der Innenaufnahme 643 des Lasermodulgehäuses 210 angeordnet und vorzugsweise fixiert. Der Aufnahmeabschnitt 711 bildet dabei den Kollimationslinsen-Halter 220 aus. Die Kollimationslinse 230 ist vorzugsweise mittels einer stoffschlüssigen Verbindung, insbesondere einer Klebeverbindung, und/oder einer Pressverbindung in der Innenaufnahme 643 bzw. dem Aufnahmeabschnitt 711 fixiert.

Des Weiteren ist, wie oben beschrieben, der zylindrische Grundkörper 635 des Laserdioden-Halters 660 in der Innenaufnahme 643, insbesondere in einem illustrativ unteren Aufnahmeabschnitt 712, angeordnet. Bevorzugt ist dabei zumindest abschnittsweise zwischen einem Außenumfang 713 des zylindrischen Grundkörpers 635 und dem Aufnahmeabschnitt 712 eine Pressverbindung ausgebildet. Alternativ kann der zylindrische Grundkörper 635 über eine stoffschlüssige Verbindung in der Innenaufnahme 643 bzw. dem Aufnahmeabschnitt 712 fixiert sein.

Darüber hinaus ist vorzugsweise der erste Leiterplattenabschnitt 611 der flexiblen und faltbaren Leiterplatte 300 am Laserdioden-Halter 660 fixiert. Bevorzugt ist der erste Leiterplattenabschnitt 611 mittels einer stoffschlüssigen Verbindung 1898 am Laserdioden-Halter 660 fixiert. Vorzugsweise ist die stoffschlüssige Verbindung 1898 zwischen einer dem Laserdioden-Halter 660 zugewandten Oberseite 732 des ersten Leiterplattenabschnitts 611 der flexiblen und faltbaren Leiterplatte 300 und einer dem ersten Leiterplattenabschnitt 611 zugewandten Unterseite 731 des Umfangskragens 637 des Laserdioden-Halters 660 ausgebildet.

Des Weiteren ist der zweite Leiterplattenabschnitt 610 der flexiblen und faltbaren Leiterplatte 300 vorzugsweise mittels einer stoffschlüssigen Verbindung 1899 an dem Fotodioden-Halter 622 fixiert. Insbesondere ist dabei eine von der Fotodiode 260 abgewandte Seite 735 des zweiten Leiterplattenabschnitts 610 illustrativ mittels der stoffschlüssigen Verbindung 1899 an einer dem zweiten Leiterplattenabschnitt 610 zugewandten Seite 736 des Fotodioden-Halters 622 befestigt. Der Fotodioden-Halter 622 ist bevorzugt mittels einer Presspassung in der Innenaufnahme 643, vorzugsweise in dem illustrativ unteren Aufnahmeabschnitt 712 des Lasermodulgehäuses 210, fixiert. Gemäß einer Ausführungsform ist zumindest eine stoffschlüssige Verbindung 1898, 1899 eine Klebeverbindung.

Darüber hinaus visualisiert Fig. 7 den Laserdioden-Halter 660 mit dem zylindrischen Grundkörper 635, der an seinem Außenumfang eine Aufnahme 631 aufweist. Die Aufnahme 631 weist bevorzugt eine Ausnehmung 721 zur Anordnung der Fotodiode 260 in der Innenaufnahme 636 des Laserdioden-Halters 660 auf. Vorzugsweise ist die Ausnehmung 721 innerhalb vorgegebener Toleranzen senkrecht zur Aufnahme 631 angeordnet.

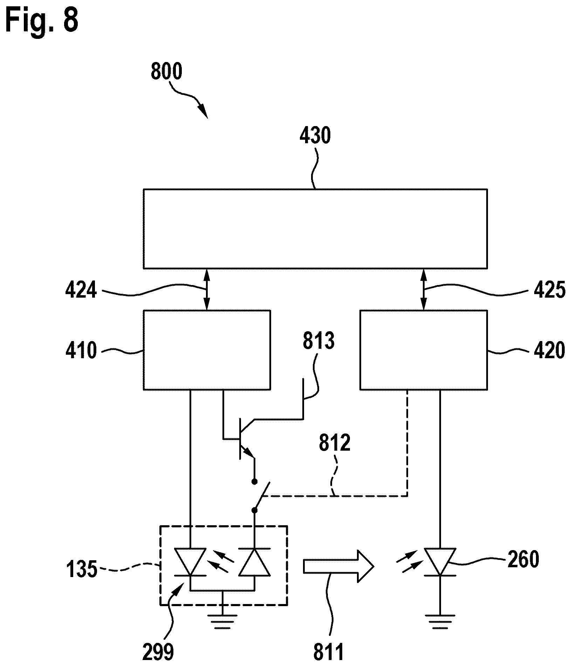

Fig. 8 zeigt eine beispielhafte, der Lasereinheit 130 von Fig. 2 oder Fig. 5 bis Fig. 7 zugeordnete Schaltung 800. Die Schaltung 800 weist beispielhaft analog zur Schaltung 400 von Fig. 4 die der Fotodiode 260 zugeordnete Schutzschaltung 420 auf, die über die Verbindung 425 mit weiteren Schaltungsteilen 430 verbunden ist, sowie die der Laserdiode 135 zugeordnete, automatische Leistungsregelungsschaltung 410, die über die Verbindung 424 mit den weiteren Schaltungsteilen 430 verbunden ist. Die weiteren Schaltungsteile 430 umfassen, wie oben beschrieben, z.B. eine Strom-/Spannungsversorgung und/oder eine Steuereinheit, insbesondere die Elektronikeinheit 190 von Fig. 1 des Rotationslasers 100 von Fig. 1.

Die Fotodiode 260 ist illustrativ mit der Laserdiode 135 durch ein der Laserdiode 135 zugeordnetes Streulicht 811 optisch gekoppelt. Alternativ kann eine optische Einkopplung über einen Strahlenteiler, z. B. den Strahlenteiler 270 von Fig. 2 bzw. die ausgehende Seite 272 des Strahlenteilers 270 von Fig. 2, erfolgen. Die automatische Leistungsregelungsschaltung 410 misst die Laserleistung mittels des Fotostroms der in der Laserdiode 135 integrierten Monitordiode 299 und regelt die Stromzufuhr zur Laserdiode 260. Die Schutzschaltung 420 misst die Laserleistung mittels des Fotostroms der Fotodiode 260.

Die Schutzschaltung 420 ist bevorzugt dazu ausgebildet, die Laserdiode 135 über eine Steuerleitung 812 durch eine Unterbrechung einer der Laserdiode 135 zugeordneten Stromzufuhr 813 zur Laserdiode 135 zu deaktivieren, falls die von der Fotodiode 260 gemessene Laserleistung einen vorgegebenen Laserleistungsgrenzwert überschreitet. Alternativ deaktiviert die Schutzschaltung 420 die automatische Leistungsregelungsschaltung 410 über eine zugeordnete Steuerleitung, wie bei Fig. 4 beschrieben.

Fig. 9 zeigt die flexible und faltbare Leiterplatte 300 von Fig. 6 und Fig. 7 mit dem ersten Leiterplattenabschnitt 611, auf dem die Laserdiode 135 angeordnet ist, und mit dem illustrativ senkrecht zum ersten Leiterplattenabschnitt 611 angeordneten zweiten Leiterplattenabschnitt 610 mit der Fotodiode 260 und dem Fotodioden-Halter 622. Bevorzugt weist die Laserdiode 135 eine Abstrahlcharakteristik 911 mit einer Divergenz, also einer Aufweitung des Laserstrahls 253 über eine bestimmte Distanz, die einen elliptischen Querschnitt 920 aufweist, auf. Die Divergenz des von der Laserdiode 135 emittierten Laserstrahls 253 ist dabei vorzugsweise senkrecht zu einer optischen Achse 912 des Laserstrahls 253 ausgebildet.

Durch den elliptischen Querschnitt weist die Divergenz vorzugsweise in einer ersten Richtung 921, die senkrecht zur optischen Achse 912 verläuft, einen vergleichsweise kleinen Wert auf und in einer senkrecht zur optischen Achse 912 und senkrecht zur ersten Richtung 921 angeordneten, zweiten Richtung 922 weist die Divergenz bevorzugt einen vergleichsweise großen Wert auf. Um eine möglichst gute Einkopplung des Streulichts 811 in die Fotodiode 260 zu erreichen, wird die Fotodiode 260 daher vorzugsweise im Wesentlichen/annähernd entlang der Richtung 922 der größten Divergenz relativ zur Laserdiode 135 positioniert.

Mit Kenntnis der Divergenz der Laserdiode 135 kann eine geeignete Position der Fotodiode 260 relativ zur optischen Achse 912 des Laserstrahls 253 der Laserdiode 135 in radialer Richtung 902 und axialer Richtung 903 ermittelt werden, die eine Laserleistungsmessung durch die Schutzschaltung 420 mit ausreichendem Störabstand bei gleichzeitigem Ausschluss einer Verschattung des optischen Pfades zwischen Laserdiode 135 und Kollimationslinse 230 in Fig. 5 bis Fig. 7 durch die Fotodiode 260 ermöglicht.

Fig. 10 zeigt die Anordnung der Fotodiode 260 zur Laserdiode 135 gesehen in Richtung eines Pfeils 901 von Fig. 9, zur Verdeutlichung der Abstrahlcharakteristik 911 der Laserdiode 135. Hierdurch werden der elliptische Querschnitt 920 sowie die vorzugsweise der kleinsten Divergenz zugeordnete erste Richtung 921 und die bevorzugt der größten Divergenz zugeordnete zweite Richtung 922 verdeutlicht. Wie oben beschrieben, ist die Fotodiode 260 vorzugsweise im Wesentlichen/annähernd in der Richtung 922 der größten Divergenz angeordnet.

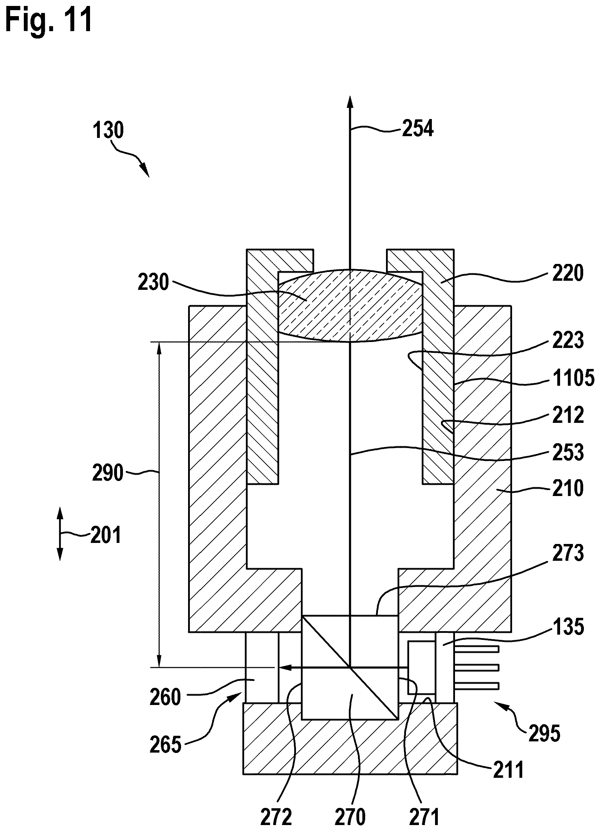

Fig. 11 zeigt die Lasereinheit 130 von Fig. 2 mit einer alternativen Ausgestaltung des Kollimationslinsen-Halters 220. Der Kollimationslinsen-Halter 220 weist dabei vorzugsweise lediglich die Linsenaufnahme 223 auf, in der die Kollimationslinse 230 angeordnet ist. Ein Außenumfang 1105 des Kollimationslinsen-Halters 220 ist bevorzugt in der Innenaufnahme 212 des Lasermodulgehäuses 210 angeordnet. Dabei ist der Kollimationslinsen-Halter 220 illustrativ in der Innenaufnahme 212 des Lasermodulgehäuses 210 entlang der Längserstreckung 201 des Lasermodulgehäuses 210 zur Einstellung des Abstands 290 zwischen der Laserdiode 135 und der Kollimationslinse 230 in der Innenaufnahme 212 verschiebbar abgeordnet.

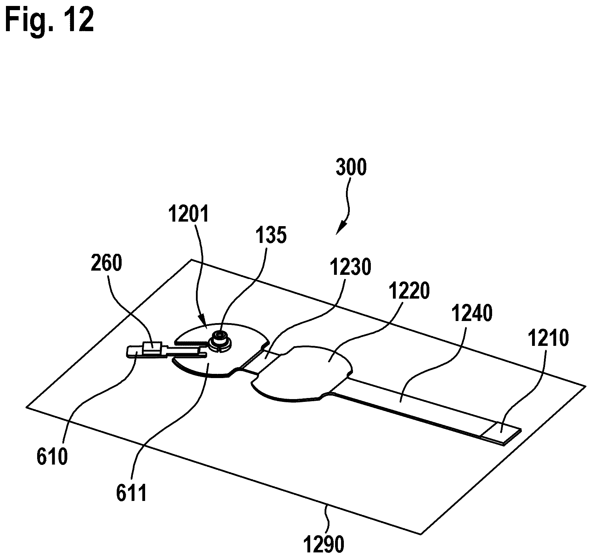

Fig. 12 zeigt die flexible und faltbare Leiterplatte 300 von Fig. 3 in aufgefaltetem Zustand mit dem ersten Leiterplattenabschnitt 611, auf dem die Laserdiode 135 angeordnet ist, und dem zweiten Leiterplattenabschnitt 610 mit der Fotodiode 260, von einer Oberseite 1201 der Leiterplatte 300 aus betrachtet. Dabei ist der zweite Leiterplattenabschnitt 610 illustrativ in einer gemeinsamen Ebene 1290 mit dem ersten Leiterplattenabschnitt 611 angeordnet.

Illustrativ ist ein parallel zum ersten Leiterplattenabschnitt 611 anordenbarer, dritter Leiterplattenabschnitt 1220 vorgesehen. Illustrativ ist der dritte Leiterplattenabschnitt 1220 ebenfalls in der Ebene 1290 angeordnet. Der dritte Leiterplattenabschnitt 1220 ist dabei vorzugsweise über einen Verbindungsabschnitt 1230 mit dem ersten Leiterplattenabschnitt 611 verbunden.

Bevorzugt ist der erste Leiterplattenabschnitt 611 oder der dritte Leiterplattenabschnitt 1220 über einen flexiblen Verbindungsabschnitt 1240 mit einem Kontaktierungselement 1210 verbunden. Illustrativ ist der dritte Leiterplattenabschnitt 1220 über den flexiblen Verbindungsabschnitt 1240 mit dem Kontaktierungselement 1210 verbunden. Das Kontaktierungselement 1210 ist vorzugsweise lediglich auf der Oberseite 1201 der Leiterplatte 300 ausgebildet.

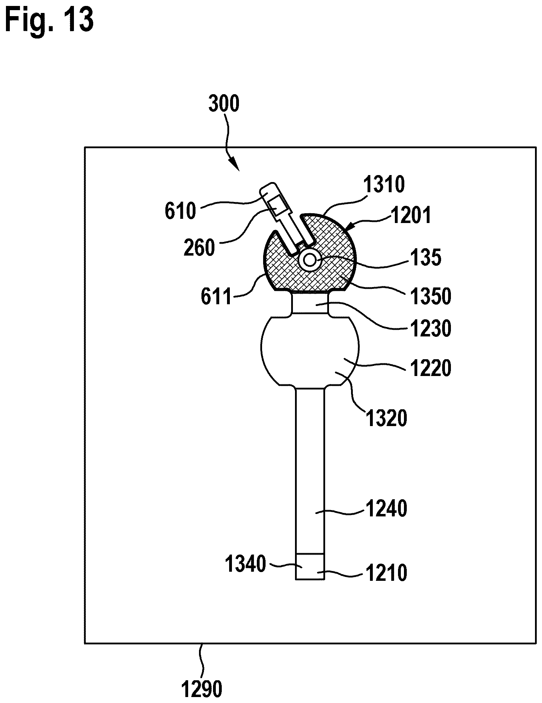

Fig. 13 zeigt die flexible und faltbare Leiterplatte 300 von Fig. 12 in der Ebene 1290 von der Oberseite 1201 aus betrachtet. Bevorzugt weisen der erste Leiterplattenabschnitt 611, der dritte Leiterplattenabschnitt 1220 und/oder das Kontaktierungselement 1210 Verstärkungselemente 1310, 1320, 1340 auf. Illustrativ ist dem ersten Leiterplattenabschnitt 611 ein Verstärkungselement 1310 zugeordnet, dem dritten Leiterplattenabschnitt 1220 ein Verstärkungselement 1320 und dem Kontaktierungselement 1210 ein Verstärkungselement 1340.

Beispielhaft ist dem ersten Leiterplattenabschnitt 611 zumindest abschnittsweise ein Fixierelement 1350 zur Ausbildung der stoffschlüssigen Verbindung 1898 mit dem Laserdioden-Halter 660 von Fig. 6 und Fig. 7 zugeordnet. Vorzugsweise ist das Fixierelement 1350 ein doppelseitiges Klebeband.

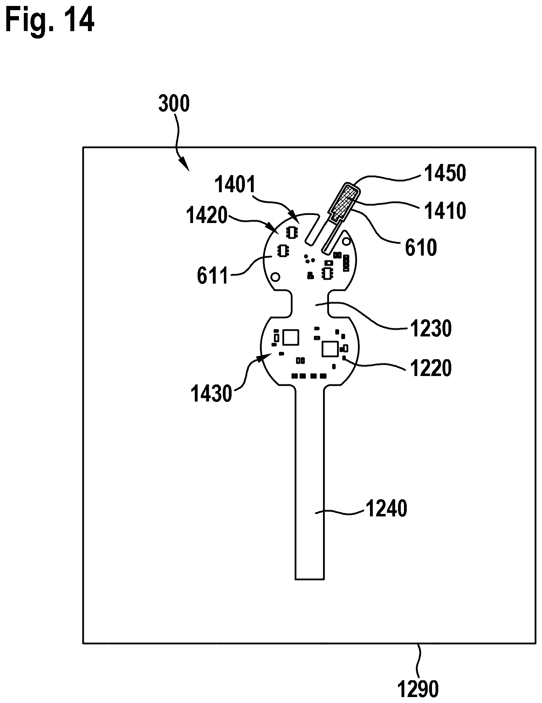

Fig. 14 zeigt die flexible und faltbare Leiterplatte 300 von Fig. 12 und Fig. 13 in der Ebene 1290 von einer der Oberseite 1201 von Fig. 12 und Fig. 13 gegenüberliegenden Unterseite 1401 aus betrachtet. Der erste Leiterplattenabschnitt 611 und/oder der dritte Leiterplattenabschnitt 1220 weisen vorzugsweise auf der Unterseite 1401 elektrische Bauteile 1420, 1430 auf. Illustrativ sind die elektrischen Bauteile 1420 dem ersten Leiterplattenabschnitt 611 zugeordnet und die elektrischen Bauteile 1430 sind dem dritten Leiterplattenabschnitt 1220 zugeordnet.

Vorzugsweise ist dem zweiten Leiterplattenabschnitt 610 ein Verstärkungselement 1450 zugeordnet. Bevorzugt ist dem zweiten Leiterplattenabschnitt 610 zumindest abschnittsweise ein Fixierelement 1410 zur Ausbildung der stoffschlüssigen Verbindung 1899 mit dem Fotodioden-Halter 622 von Fig. 6 und Fig. 7 zugeordnet. Vorzugsweise ist das Fixierelement 1410 ein doppelseitiges Klebeband.

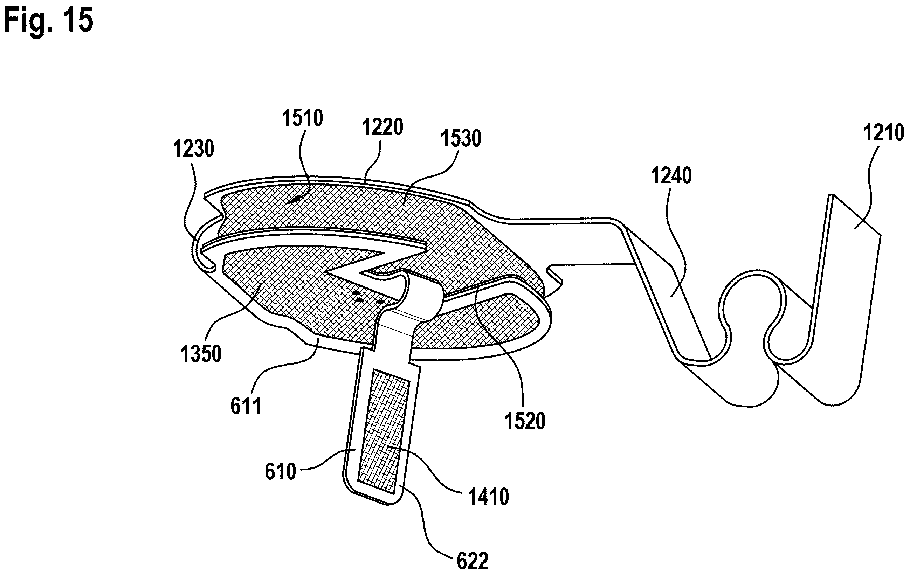

Fig. 15 zeigt die flexible und faltbare Leiterplatte 300 von Fig. 12 bis Fig. 14 im gefalteten Zustand, in dem der zweite Leiterplattenabschnitt 610 zumindest annähernd senkrecht zum ersten Leiterplattenabschnitt 611 angeordnet ist und der dritte Leiterplattenabschnitt 1220 zumindest annähernd parallel zum ersten Leiterplattenabschnitt 611 angeordnet ist. Des Weiteren ist illustrativ der flexible Verbindungsabschnitt 1240 gefaltet. Dabei verdeutlicht Fig. 15 das dem ersten Leiterplattenabschnitt 611 zugeordnete Fixierelement 1350 und das dem zweiten Leiterplattenabschnitt 610 zugeordnete Fixierelement 1410.

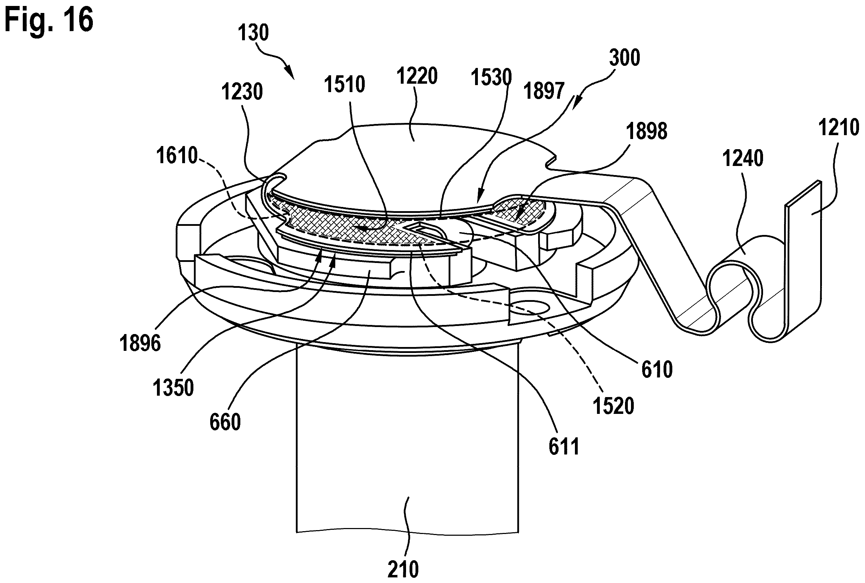

Vorzugsweise bilden der erste und dritte Leiterplattenabschnitt 611, 1220 eine Aufnahme 1510 aus. Die Aufnahme 1510 ist bevorzugt nach Art eines Sandwiches ausgebildet. In der Aufnahme 1510 ist vorzugsweise ein Abstandshalteelement (1610 in Fig. 16) anordenbar. Beispielhaft ist dem ersten und/oder dritten Leiterplattenabschnitt 611, 1220 zumindest abschnittsweise ein Fixierelement 1520, 1530 zur Ausbildung einer stoffschlüssigen Verbindung (1896, 1897 in Fig. 16) zugeordnet.

Fig. 16 zeigt die Lasereinheit 130 von Fig. 6 und Fig. 7 mit der flexiblen und faltbaren Leiterplatte 300 von Fig. 12 bis Fig. 15. Dabei ist in der zwischen dem ersten und dritten Leiterplattenabschnitt 611, 1220 ausgebildeten Aufnahme 1510 ein Abstandshalteelement 1610 angeordnet. Durch das Abstandshalteelement 1610, insbesondere durch eine ausreichende Dicke des Abstandshalteelements 1610, kann eine Kontrolle eines Biegeradius des Verbindungsabschnitts 1230 der Leiterplatte 300 erfolgen. Des Weiteren dient das Abstandshalteelement 1610 als elektrische Isolation, um einen Kurzschluss zwischen dem ersten und dritten Leiterplattenabschnitt 611, 1220 zu verhindern. Dabei werden auch die auf dem ersten und/oder dritten Leiterplattenabschnitt 611, 1220 angeordneten Bauteile 1420, 1430 mechanisch geschützt.

Das Abstandshalteelement 1610 ist vorzugsweise mittels einer stoffschlüssigen Verbindung 1897, 1896 am ersten Leiterplattenabschnitt 611 und/oder am dritten Leiterplattenabschnitt 1220 fixiert. Vorzugsweise sind die stoffschlüssigen Verbindungen 1897, 1896 Klebeverbindungen, wobei das dem ersten Leiterplattenabschnitt 611 zugeordnete Fixierelement 1520 und/oder das dem dritten Leiterplattenabschnitt 1220 zugeordnete Fixierelement 1530 mit dem Abstandshalteelement 1610 die jeweilige Klebeverbindung 1896, 1897 ausbilden. Vorzugsweise weist das Abstandshalteelement 1610 einen nicht elektrisch leitenden Werkstoff auf.

Bevorzugt weist das Abstandshalteelement 1610 einen weichen Werkstoff auf. Beispielhaft weist das Abstandshalteelement 1610 Schaumstoff, Gummi oder Filz auf. Alternativ ist das Abstandshalteelement 1610 ein Spritzgussteil.

Des Weiteren verdeutlicht Fig. 16 die stoffschlüssige Verbindung 1898 des ersten Leiterplattenabschnitts 611 mit dem Laserdioden-Halter 660 über das beispielhafte Fixierelement 1350.

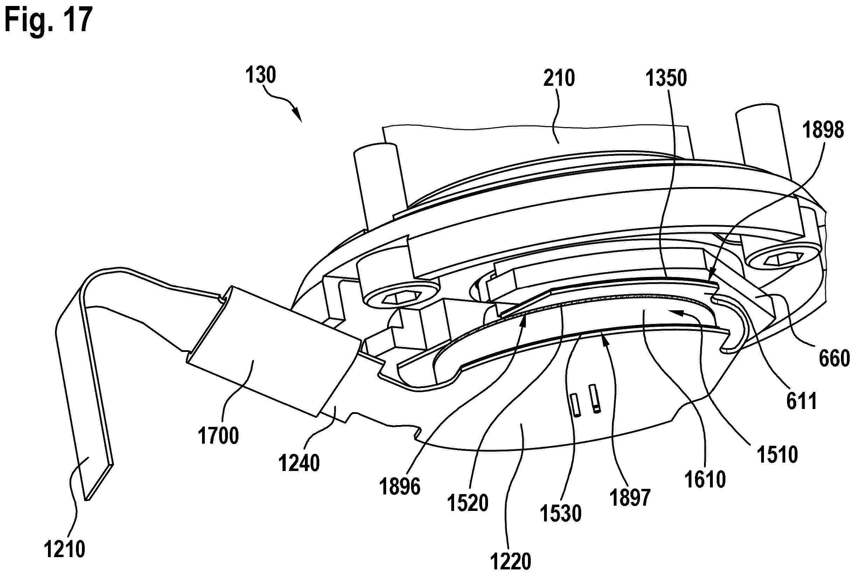

Fig. 17 zeigt die Lasereinheit 130 von Fig. 16. Illustrativ ist der flexiblen und faltbaren Leiterplatte 300 ein Abschirmungselement 1700 zugeordnet. Vorzugsweise ist das Abschirmungselement 1700 mittels einer stoffschlüssigen Verbindung, einer Rastverbindung und/oder einer Pressverbindung an der flexiblen und faltbaren Leiterplatte 300 fixiert. Bevorzugt ist das Abschirmungselement 1700 am flexiblen Verbindungsabschnitt 1240 angeordnet.

Vorzugsweise weist das Abschirmungselement 1700 Ferrit auf. Das Abschirmungselement 1700 ist dazu ausgebildet, die elektromagnetische Verträglichkeit (EMV) der Lasereinheit 130 zu verbessern.

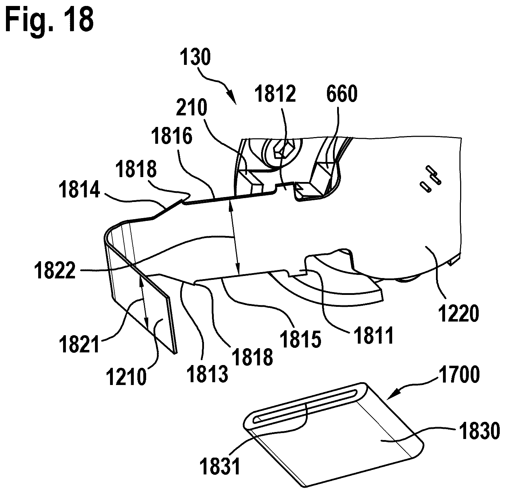

Fig. 18 zeigt die Lasereinheit 130 von Fig. 17, wobei das Abschirmungselement 1700 illustrativ neben dem flexiblen Verbindungsabschnitt 1240 angeordnet ist.

Bevorzugt weist die flexible und faltbare Leiterplatte 300 einen Aufnahmebereich 1815, 1816 auf, der vorzugsweise durch seitliche Stege 1811, 1812, 1813, 1814 begrenzt ist. Beispielhaft weist das Abschirmungselement 1700 eine Innenaufnahme 1831 zur Anordnung im Aufnahmebereich 1815, 1816 der flexiblen und faltbaren Leiterplatte 300 auf.

Illustrativ weist das Kontaktierungselement 1210 eine Breite 1821 auf, die sich über zumindest einen rampenartigen Steg 1813, 1814, illustrativ über zwei gegenüberliegende rampenartige Stege 1813, 1814, in eine Breite 1822 des Aufnahmebereichs 1815, 1816 aufweitet. Die beiden rampenartige Stege 1813, 1814 bilden dabei bevorzugt eine Rastfunktion mit Anstehkanten 1818 aus. Die Anstehkanten 1818 verhindern vorzugsweise ein Abrutschen des Abschirmungselements 1700 vom Aufnahmebereich 1815, 1816 der Leiterplatte 300.

Bevorzugt ist zumindest ein Steg, illustrativ die Stege 1811, 1812, vorsprungsartig ausgebildet und bildet dabei eine Anschlagsfunktion aus. Die Stege 1811, 1812, 1813, 1814 weisen dabei vorzugsweise eine Breite auf, die breiter als die Breite 1822 ist, die zwischen den Aufnahmebereichen 1815, 1816 ausgebildet ist. Alternativ oder optional ist zwischen dem Aufnahmebereich 1815, 1816 und der Innenaufnahme 1831 des Abschirmungselements 1700 eine Presspassung aufgrund von einem Übermaß des Aufnahmebereichs 1815, 1816 ausgebildet.

Das Abschirmungselement 1700 wird vorzugsweise bei der Montage im Bereich des Kontaktelements 1210 auf die Leiterplatte 300 aufgeschoben und über die rampenartigen Stege 1813, 1814 im Aufnahmebereich 1815, 1816 angeordnet.

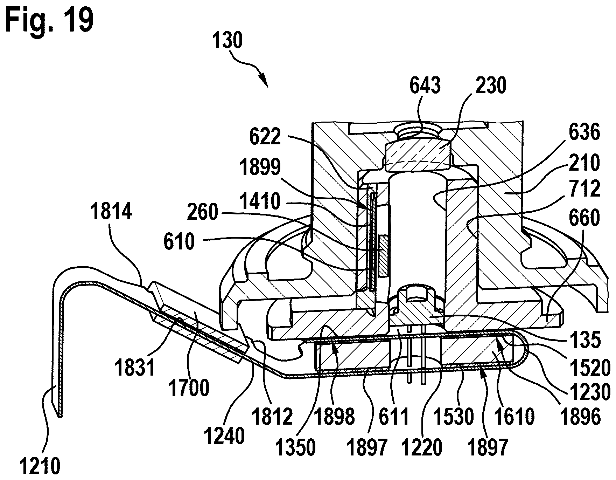

Fig. 19 zeigt die Lasereinheit 130 von Fig. 17 und Fig. 18 mit dem Abschirmungselement 1700 auf dem flexiblen Verbindungsabschnitt 1240 der flexiblen und faltbaren Leiterplatte 300. Des Weiteren verdeutlicht Fig. 19 die stoffschlüssigen Verbindungen 1896, 1897, 1898, 1899, die beispielhaft jeweils mittels Fixierelementen, insbesondere Klebeelementen 1520, 1530, 1350, 1410, ausgebildet sind. Bevorzugt sind die Fixierelemente 1520, 1530, 1350, 1410 als Klebeelemente ausgebildet. Es wird darauf hingewiesen, dass die stoffschlüssigen Verbindungen 1896, 1897, 1898, 1899 auch als Lötverbindungen oder dergleichen ausgebildet sein können.

Alternativ ist die flexible und faltbare Leiterplatte 300 bzw. der erste Leiterplattenabschnitt 611 mittels einer Lötverbindung der im Laserdioden-Halter 660 eingepressten Laserdiode 135 am ersten Leiterplattenabschnitt 611 am Laserdioden-Halter 660 befestigt.

## Patentansprüche

1. Lasereinheit (130) für einen Rotationslaser (100), mit einem Lasermodulgehäuse (210), in dem eine Laserdiode (135) zur Erzeugung eines Laserstrahls (251) sowie eine Kollimationslinse (230) zur Kollimation des Laserstrahls (251) angeordnet sind, wobei der Laserdiode (135) eine Monitordiode (299) zugeordnet ist, und wobei eine automatische Leistungsregelungsschaltung (410) zur automatischen Reglung einer Laserleistung der Laserdiode (135), basierend auf einer Messung der Laserleistung durch die Monitordiode (299), vorgesehen ist, **dadurch gekennzeichnet, dass** eine Fotodiode (260) für eine von der Monitordiode (299) unabhängige Messung der Laserleistung vorgesehen ist.

2. Lasereinheit nach Anspruch 1, **dadurch gekennzeichnet, dass** die Monitordiode (299) eine in die Laserdiode (135) integrierte Monitordiode ist.

3. Lasereinheit nach Anspruch 1 oder 2, **dadurch gekennzeichnet, dass** die Fotodiode (260) einer Schutzschaltung (420) zugeordnet ist, welche dazu ausgebildet ist, die Laserdiode (135) über eine Steuerleitung (812) durch eine Unterbrechung der Stromzufuhr zur Laserdiode (135) zu deaktivieren oder die automatische Leistungsregelungsschaltung (410) über eine Steuerleitung (423) zu deaktivieren, falls die von der Fotodiode (260) gemessene Laserleistung einen vorgegebenen Laserleistungsgrenzwert überschreitet.

4. Lasereinheit nach einem der vorhergehenden Ansprüche, **dadurch gekennzeichnet, dass** der Laserdiode (135) ein Laserdioden-Halter (295; 660), der Fotodiode (260) ein Fotodioden-Halter (265; 622) und/oder der Kollimationslinse (230) ein Kollimationslinsen-Halter (220) zugeordnet sind.

5. Lasereinheit nach Anspruch 4, **dadurch gekennzeichnet, dass** das Lasermodulgehäuse (210) eine Aufnahme (211) aufweist, die den Laserdioden-Halter (295) zur Aufnahme der Laserdiode (135) und den Fotodioden-Halter (265) zur Aufnahme der Fotodiode (260) ausbildet, und wobei ein Strahlenteiler (270) in der Aufnahme (211) angeordnet ist, wobei die Laserdiode (135) auf einer eingehenden Seite (271) des Strahlenteilers (270) angeordnet ist und die Fotodiode (260) auf einer ausgehenden Seite (272) des Strahlenteilers (270) angeordnet ist.

6. Lasereinheit nach Anspruch 5, **dadurch gekennzeichnet, dass** die Kollimationslinse (230) auf einer weiteren ausgehenden Seite (273) des Strahlenteilers (270) angeordnet ist.

7. Lasereinheit nach Anspruch 4, **dadurch gekennzeichnet, dass** das Lasermodulgehäuse (210) eine erste Aufnahme (501) aufweist, die als Fotodioden-Halter (265) zur Aufnahme der Fotodiode (260) ausgebildet ist und eine zweite Aufnahme (502) aufweist, die als Laserdioden-Halter (295) zur Aufnahme der Laserdiode (135) ausgebildet ist, wobei die erste Aufnahme (501) senkrecht zur zweiten Aufnahme (502) angeordnet ist und die zweite Aufnahme (502) kollinear zu einer optischen Achse (232) der Kollimationslinse (230) angeordnet ist.

8. Lasereinheit nach Anspruch 7, **dadurch gekennzeichnet, dass** die erste Aufnahme (501) entlang einer Längserstreckung (201) des Lasermodulgehäuses (210) von der zweiten Aufnahme (502) beabstandet angeordnet ist.

9. Lasereinheit nach Anspruch 7 oder 8, **dadurch gekennzeichnet, dass** die erste Aufnahme (501) entlang einer Richtung (922) größter Divergenz einer Abstrahlcharakteristik (911) der Laserdiode (135) angeordnet ist.

10. Lasereinheit nach Anspruch 4, **dadurch gekennzeichnet, dass** eine Leiterplatte (300) vorgesehen ist, auf der die Laserdiode (135) und die Fotodiode (260) angeordnet sind, wobei die Leiterplatte (300) und der Fotodioden-Halter (622) am Laserdioden-Halter (660) angeordnet sind.

11. Lasereinheit nach Anspruch 10, **dadurch gekennzeichnet, dass** die Leiterplatte (300) zumindest einen ersten Leiterplattenabschnitt (611) und einen senkrecht oder parallel zum ersten Leiterplattenabschnitt (611) angeordneten zweiten Leiterplattenabschnitt (610) aufweist, wobei die Laserdiode (135) am ersten Leiterplattenabschnitt (611) angeordnet ist und die Fotodiode (260) am zweiten Leiterplattenabschnitt (610) angeordnet ist.

12. Lasereinheit nach Anspruch 10 oder 11, **dadurch gekennzeichnet, dass** die Leiterplatte (300) als flexible Leiterplatte ausgebildet ist.

13. Lasereinheit nach einem der Ansprüche 4 bis 12, **dadurch gekennzeichnet, dass** das Lasermodulgehäuse (210) eine Aufnahme (711) aufweist, die den Kollimationslinsen-Halter (711) ausbildet.

14. Lasereinheit nach einem der Ansprüche 4 bis 13, **dadurch gekennzeichnet, dass** ein Abstand (290) zwischen der Laserdiode (135) und der Kollimationslinse (230) veränderbar ist, wobei der Laserdioden-Halter (295; 660) der Laserdiode (135) in einer Aufnahme (502; 643) des Lasermodulgehäuses (210) entlang der Längserstreckung (201) des Lasermodulgehäuses (210) verschiebbar angeordnet ist und/oder der Kollimationslinsen-Halter (220) der Kollimationslinse (230) in einer Innenaufnahme (212) des Lasermodulgehäuses (210) entlang der Längserstreckung (201) des Lasermodulgehäuses (210) verschiebbar angeordnet ist, wobei die Innenaufnahme (212) kollinear zu einer optischen Achse (232) der Kollimationslinse (230) angeordnet ist.

15. Rotationslaser (100) mit einer Lasereinheit (130) nach einem der vorhergehenden Ansprüche.
